# EUROPÄISCHE PATENTSCHRIFT

(11) **EP 4 352 826 B1**
(45) Veröffentlichungstag und Bekanntmachung des Hinweises auf die Patenterteilung: **11.03.2026**
(21) Anmeldenummer: 22730690.9
(22) Anmeldetag: 18.05.2022
(51) Int. Cl.: H01R 13/03, H01R 4/50, H01R 13/58, H01R 43/28, H01R 12/51, H01R 13/50

(54) **ELEKTRISCHER VERBINDER**
ELECTRICAL CONNECTOR
CONNECTEUR ÉLECTRIQUE

(30) Priorität: 07.06.2021 CH 6642021
(43) Veröffentlichungstag der Anmeldung: 17.04.2024
(73) Patentinhaber: Harting AG, 2504 Biel (CH)
(72) Erfinder: ZENKER, Matthias, 32339 Espelkamp (DE)
(74) Vertreter: Rentsch Partner AG
(86) Internationale Anmeldenummer: PCT/EP2022/063434
(87) Internationale Veröffentlichungsnummer: WO 2022/258328

(56) Entgegenhaltungen:
- WO-A1-2012/175184
- DE-C1- 19 823 509
- DE-U1- 29 605 034

## Beschreibung

### TECHNISCHES GEBIET

Die vorliegende Erfindung betrifft elektrische Verbinder zum Anschluss von Drähten an eine elektrische Schaltung, Leiterplatte oder Baugruppe. Die Erfindung betrifft ferner ein Verfahren zum Anschliessen eines Drahtes.

### TECHNISCHER HINTERGRUND, STAND DER TECHNIK

Die Aufgabe des elektrischen Anschlusses von Drähten an eine Schaltung, Leiterplatte, Baugruppe oder dergleichen ergibt sich in vielen Bereichen der Elektrotechnik in unterschiedlichster Ausprägung. Als Anforderungen stehen dabei neben der elektrischen und mechanischen Zuverlässigkeit im Betrieb grundsätzlich eine gewünschte einfache Herstellung und gegebenenfalls Lösen der Verbindung, eine fehlersichere Handhabung sowie geringe Kosten sowohl für die verwendeten Komponenten als auch für die Durchführung der Montage. Häufig kommen weitere Anforderungen aufgrund von Randbedingungen wie beengten Platzverhältnisse und eingeschränkter Sicht hinzu.

Besonders kritisch und schwer erfüllbar sind diese und ggf. weitere Anforderungen im Feldeinsatz, z. B. bei der Installation elektrischer Anlagen sowie deren Wartung und Reparatur. So ist mitunter aufgrund der Platzverhältnisse eine einhändige Arbeit erforderlich.

Die DE29605034U 1 offenbart einen Steckverbinder für elektrische Leitungen mit mehreren Leitern, insbesondere für Flachleitungen. Die Stecker und/oder Buchsen des Steckverbinders sind dabei jeweils in einem Gehäuse mit einer Klemmvorrichtung für das gleichzeitige Einstecken und anschliessende gleichzeitige Klemmen der elektrischen Leiter angeordnet.

### ZUSAMMENFASSUNG DER ERFINDUNG

Es zeigt sich, dass bekannte Verfahren und Vorrichtungen, wie Löten, Leitkleben und Crimpen die gestellten Anforderungen häufig nicht oder nur unzulänglich erfüllen können.

Vor diesem Hintergrund ist es Aufgabe der vorliegenden Erfindung, den Stand der Technik hinsichtlich des Anschliessens von Drähten weiterzuentwickeln. Bevorzugt wird dabei die Situation hinsichtlich einer oder mehrerer der eingangs genannten Probleme verbessert.

Die technische Aufgabe wird durch den Gegenstand der unabhängigen Patentansprüche gelöst. Die abhängigen Ansprüche sowie die Beschreibung und die Zeichnungen definieren beispielhafte sowie vorteilhafte Ausführungsformen.

Gemäss einem Aspekt wird die technische Aufgabe durch einen elektrischen Verbinder für einen Draht mit einem Drahtende gelöst. Vom Drahtende aus erstrecken sich ein unisoliertes Drahtsegment und ein sich an das unisolierte Endsegment angrenzendes isoliertes Drahtsegment. Gemeinsam bilden das unisolierte und das isolierte Drahtsegment einen Einführabschnitt. Der Draht weist somit an einem sich bis zum Drahtende erstreckenden Abschnitt, welcher das unisolierte Drahtsegment bildet, keine Isolation auf. Dabei wird das unisolierte Drahtsegment typischerweise durch Entfernen einer ursprünglich vorhandenen Isolation bzw. durch Abisolieren erzeugt. In der vom Drahtende wegweisenden Richtung kann der Draht im Anschluss an das isolierte Drahtsegment des Einführabschnitts ebenfalls isoliert sein, beziehungsweise der isolierte Draht kann einen Endbereich eines isolierten Teils des Drahtes darstellen. Dieser isolierte Teil des Drahtes kann grundsätzlich eine beliebige Länge aufweisen.

Der elektrische Verbinder ist von einer geöffneten Konfiguration in eine geschlossene Konfiguration überführbar. In einer speziellen Ausführungsform ist der Verbinder ebenfalls vorzugsweise zerstörungsfrei von der geschlossenen Konfiguration in die geöffnete Konfiguration überführbar.

Der Verbinder weist einen Verbinderkörper mit einer proximalen und einer distalen Verbinderkörperseite sowie einer Verbinderkörperoberseite auf. Der Verbinderkörper weist ferner einen Kanal zur Aufnahme des Einführabschnitts auf. Der Kanal erstreckt sich im Verbinderkörper entlang einer Kanalachse von einem proximalen Kanalende in distaler Richtung, wobei das proximale Kanalende in die proximale Verbinderkörperseite mündet. Der Kanal weist ferner eine zur Verbinderkörperoberseite hin offene Kanaloberseite und einen Kanalgrund auf. Als Kanaltiefe wird eine Distanz von der Verbinderkörperoberseite zum Kanalgrund und als Kanalbreite eine Distanz zwischen den Kanalseitenflächen bezeichnet, welche den geöffneten Kanal gemeinsam mit dem Kanalgrund begrenzen. Sowohl die Kanaltiefe als auch die Kanalbreite sind über die Kanallänge bzw. entlang der Kanalachse nicht zwingend konstant. Eine Richtung quer, insbesondere senkrecht, zur Kanalachse, welche sich zwischen offener Kanaloberseite und Kanalgrund erstreckt, wird als Tiefenrichtung und eine entsprechende Achse als Tiefenachse bezeichnet. Eine Richtung quer, insbesondere senkrecht, zur Kanalachse und zur Tiefenachse wird als laterale Richtung und eine entsprechende Achse als laterale Achse bezeichnet. Die laterale Achse erstreckt sich zwischen den Kanalseitenflächen, welche die offene Kanaloberseite mit dem Kanalgrund verbinden. Eine Ansicht entlang der Tiefenachse in Richtung von der Kanaloberseite zum Kanalgrund wird als Aufsicht, eine Ansicht entlang der lateralen Achse als Seitansicht und eine Ansicht entlang der Kanalachse von proximal nach distal als Frontansicht bezeichnet.

Der Verbinderkörper ist aus elektrisch isolierendem Material, insbesondere Kunststoff, geformt.

Der Kanal kann senkrecht zur Kanalachse einen zum Beispiel im Wesentlichen U-förmigen Querschnitt aufweisen, welcher durch die Kanalseitenflächen als Begrenzungen in lateraler Richtung beziehungsweise Schenkel des U's sowie den Kanalgrund als Basis des U's begrenzt wird. In einer Ausgestaltung sind die Kanalseitenflächen zueinander im Wesentlichen parallel oder bei variierender Kanalbreite abschnittsweise parallel. Der Kanalgrund kann unterbrochen sein beziehungsweise Öffnungen zu einer Verbinderkörperunterseite aufweisen. Ebenso können die Kanalseitenflächen Unterbrechungen beziehungsweise Ausschnitte aufweisen, welche den Kanalinnenraum mit lateralen Verbinderkörperseiten verbinden, welche den elektrischen Verbinder in lateraler Richtung begrenzen und seine lateralen Aussenflächen definieren können. Sich zwischen dem Kanal und den lateralen Verbinderkörperseiten erstreckende Teile des Verbinderkörpers werden als Verbinderkörperseitenwände bezeichnet und ein sich zwischen Kanalgrund und Verbinderkörperunterseite erstreckende Teil des Verbinderkörpers erstreckender Teil des Verbinderkörpers wird als Verbinderkörperbasis bezeichnet.

Die Kanalseitenflächen und der Kanalgrund können in einem scharfen Winkel, beispielsweise rechtwinklig aufeinandertreffen. Der Übergangsbereich kann aber auch einen kontinuierlichen Übergang mit einer Rundung aufweisen.

In einer weiteren Ausgestaltung ist der Kanalgrund im Querschnitt V-förmig gestaltet sein und weist dann in lateraler Richtung jeweils einen Abschnitt beidseitig der Kanalachse auf, welche schräg aufeinandertreffen und ferner schräg auf die jeweils angrenzende Kanalseitenfläche treffen. Eine solche Ausgestaltung ist vorteilhaft, um einen sicheren Kontakt auch dann zu gewährleisten, wenn nach längerer Zeit in der geschlossenen Konfiguration die Metallisierung der Drahtkontaktfläche aufgrund eines Fliessen des Materials des Verbinderkörpers degeneriert beziehungsweise sich aufgrund dessen Fliessen in das Material des Verbinderkörpers hinarbeitet. In einer Variante kann der Kanal in seinem Querschnitt insgesamt bis zur offenen Kanaloberseite auf einem Teil oder seiner gesamten Länge V-förmig oder auch parabelförmig gestaltet sein. In einer solchen Ausgestaltung besteht keine explizite Trennung zwischen Kanalgrund einerseits und Kanalseitenflächen andererseits.

Der elektrische Verbinder weist ferner ein elektrisches Anschlusselement auf. Das elektrische Anschlusselement weist eine im Kanal angeordnete Drahtkontaktfläche zur Kontaktierung des unisolierten Drahtsegments und eine aussen am Verbinderkörper angeordnete Anschlussfläche auf. Das elektrische Anschlusselement wird durch Metallisierung, insbesondere eine partielle Metallisierung, des Verbinderkörpers gebildet.

Der elektrische Verbinder weist ferner ein Deckelelement auf. Das Deckelement weist eine Klemmstruktur auf, wobei die Klemmstruktur in der geöffneten Konfiguration des elektrischen Verbinders nicht in den Kanal hineinragt und in der geschlossenen Konfiguration des elektrischen Verbinders von der offenen Kanaloberseite her in den Kanal hineinragt. Das Deckelement kann eine Deckelelementbasis aufweisen, von welcher die Klemmstruktur abragt.

Die Klemmstruktur ist dazu ausgelegt, in der geschlossenen Konfiguration den Einführabschnitt zwischen Kanalgrund und Klemmstruktur zu klemmen und das unisolierte Drahtsegment mit der Drahtkontaktfläche in Kontakt zu halten. Die Klemmung kann dabei im Wesentlichen auf der gesamten Länge des unisolierten Drahtsegments oder auf einem Teil davon und/oder in einer Anzahl von Abschnitten entlang der Erstreckung des unisolierten Drahtsegments erfolgen. Ferner kann die Klemmung optional zusätzlich auf der gesamten Länge des isolierten Drahtsegments oder auf einem Teil davon und oder in einer Anzahl von Abschnitten entlang der Erstreckung des isolierten Drahtsegments erfolgen.

In der geschlossenen Konfiguration deckt das Deckelelement in einer Ausführungsform den Kanal beziehungsweise die offene Kanaloberseite ganz oder teilweise ab.

Es wird darauf hingewiesen, dass Richtungsbegriffe wie "Oberseite", "Unterseite", "oben", "unten", vorne", "hinten", "links" "rechts" etc. sich, soweit nicht anders erwähnt, grundsätzlich lediglich zur Beschreibung der Geometrischen Verhältnisse des elektrischen Verbinders und/oder mit dem elektrischen Verbinder im Zusammenhang stehender Elemente dienen, aber keine spezielle Lage oder Orientierung im montierten Zustand oder eine bestimmte Einbaulage implizieren. Diese können grundsätzlich beliebig sein.

Gemäss einem weiteren Aspekt wird die technische Aufgabe durch eine Verbinder-Draht-Anordnung gelöst. Die Verbinder-Draht Anordnung umfasst einen elektrischen Verbinder gemäss einer der zuvor und/oder nachfolgend beschriebenen Ausführungsformen sowie einen Draht mit einem Drahtende, wo ein sich vom Drahtende aus erstreckendes unisoliertes Drahtsegment und ein sich an das unisolierte Endsegment angrenzendes isoliertes Drahtsegment gemeinsam einen Einführabschnitt bilden, wobei der Einführabschnitt im Kanal aufgenommen ist.

Gemäss einem weiteren Aspekt wird die technische Aufgabe durch ein Verfahren zum Anschliessen eines Drahtes gelöst. Das Verfahren umfasst das Bereitstellen eines elektrischen Verbinders gemäss einer der zuvor und/oder nachfolgend beschriebenen Ausführungsformen in geöffneter Konfiguration. Das Verfahren umfasst ferner das Bereitstellen eines Drahtes mit einem Drahtende, wo ein sich vom Drahtende aus erstreckendes unisoliertes Drahtsegment und einen sich an das unisolierte Segment angrenzendes isoliertes Drahtsegment gemeinsam einen Einführabschnitt bilden. Das Verfahren umfasst ferner ein Überführen des elektrischen Verbinders von der geöffneten Konfiguration in die geschlossene Konfiguration, wodurch der Einführabschnitt in den Kanal eingelegt und zwischen Klemmstruktur und Kanalgrund geklemmt und das unisolierte Drahtsegment mit der Drahtkontaktfläche in Kontakt gebracht wird. Nach Durchführung des Verfahrens bilden der elektrische Verbinder und der Draht gemeinsam eine Verbinder-Draht-Anordnung wie zuvor beschrieben. Beim Überführen des elektrischen Verbinders von der geöffneten in die geschlossene Konfiguration kann eine Deformation des Einführabschnitts aufgrund des Kontaktes des Einführabschnitts mit dem Deckelement, insbesondere der Klemmstruktur, sowie dem Verbinderkörper, insbesondere dem Kanalgrund erfolgen. Der Draht beziehungsweise sein Einführabschnitt wird typischerweise in einer im Wesentlichen geradlinigen Ausgangsform bereitgestellt und die Deformation des Einführabschnitts erfolgt typischerweise in einer Ebene, in welcher der die Kanalachse und eine Deckelementachse wie nachfolgend beschrieben liegen, beziehungsweise in einer Ebene senkrecht zur lateralen Richtung.

Vorteilhafte Ausführungsformen des Verfahrens ergeben sich aus der nachfolgenden Beschreibung und den Figuren. Insbesondere offenbaren spezielle Ausführungsformen des elektrischen Verbinders zugleich korrespondierende Ausführungsformen des erfindungsgemässen Verfahrens.

Ein anspruchsgemässer elektrischer Verbinder kann kostengünstig und in grosser Stückzahl hergestellt werden. Dabei kann im Einsatz zugleich eine hohe Zuverlässigkeit erzielt werden. Durch das Überführen des elektrischen Verbinders von der geöffneten in die geschlossene Konfiguration wird ferner in einem einzigen Schritt bzw. durch eine einzige Bewegung sowohl eine sichere mechanische wie auch elektrische Verbindung zwischen Draht einerseits und Verbinder andererseits realisiert.

Das Bereitstellen des Drahtes und das Schliessen des Verbinders beziehungsweise seine Überführung von der geöffneten in die geschlossene Konfiguration können manuell erfolgen, wobei in einer typischen Ausgestaltung kein weiteres Werkzeug erforderlich ist. Dadurch eignet sich ein anspruchsgemässer elektrischer Verbinder insbesondere für den Feldeinsatz. Alternativ oder optional kann aber auch eine vollständige oder teilweise Automatisierung vorgesehen werden.

Der elektrische Verbinder insgesamt oder zumindest der Verbinderkörper kann gemeinsam mit dem elektrischen Anschlusselement als spritzgegossener Schaltungsträger (Molded Interconnected Device, MID) realisiert bzw. ein MID-Bauteil sein. Grundsätzlich können der Verbinderkörper und/oder das Deckelelement gegebenenfalls auch nach anderen Verfahren gefertigt sein, beispielsweise spanend und/oder durch additive Fertigungsverfahren, wie etwa 3D-Druck. Geeignete Materialien sind beispielsweise amorphe oder teilkristalline Thermoplaste, wie PC-ABS, PPA, LCP oder PEEK. Ferner können Duroplaste, beispielsweise phenolharzbasiert oder lichthärtend, und/oder Keramik verwendet werden.

Die Metallisierung kann je nach Anforderungen und Material des Verbinderkörpers verschieden aufgebaut sein und kann ein- oder mehrschichtig sein. Ein grundsätzlich gut geeigneter Schichtaufbau ist beispielsweise dreischichtig und besitzt eine Schichtfolge Kupfer (Cu) - Nickel (Ni) - Gold (Au).

Je nach Ausführungsform kann der elektrische Verbinder und insbesondere der Verbinderkörper zur Montage auf einer Leiterplatte bzw. gedruckten Schaltung (Printed Circuit Board, PCB) ausgelegt sein. Hierfür kann die Anschlussfläche zur elektrischen Kontaktierung entsprechend gestaltet und ferner eine entsprechende mechanische Schnittstelle am Verbinderkörper vorgesehen sein. Weiterhin kann der elektrische Verbinder zusätzlich oder alternativ zur Montage an einem elektrischen/elektronischen Gerät oder einer Baugruppe ausgelegt. sein. Ferner kann der elektrische Verbinder, insbesondere der Verbinderkörper, mit einem elektrischen/elektronischen Gerät oder Baugruppe integral sein und einen Teil davon bilden. So kann der elektrische Verbinder und insbesondere der Verbinderkörper selbst integraler Teil einer MID-Komponente bzw. MID-Baugruppe sein.

Bei einer Ausgestaltung als separates Bauteil kann der Verbinder und insbesondere der Verbinderkörper als langgestrecktes Element realisiert sein, dessen Längsausdehnung sich entlang der Kanalachse erstreckt. Die Gesamtlänge zwischen der proximalen Verbinderkörperseite und der distalen Verbinderkörperseite ist dabei typischerweise durch die Länge des Kanals zwischen dem proximalen Kanalende und einem distalen Kanalende gegeben bzw. geringfügig länger als diese.

In einer Blickrichtung entlang der Kanalachse kann der Verbinderkörper beispielsweise einen im Wesentlichen quadratischen oder rechteckigen Querschnitt aufweisen. Dabei kann der Kanal typischerweise symmetrisch zwischen den lateralen Verbinderkörperseiten verlaufen. Die Kanalachse kann zugleich eine Verbinderkörperachse darstellen.

Der Verbinderkörper kann eine im Wesentlichen glatte Verbinderkörperunterseite aufweisen, welche beispielsweise parallel zur Verbinderkörperoberseite verlaufen kann. Die Verbinderkörperunterseite kann zum Beispiel zur Montage auf einer Leiterplatte ausgelegt sein. Die Verbinderkörperunterseite kann optional die Anschlussfläche tragen. In einer solchen Ausgestaltung kann der Verbinder etwa zur Oberflächenmontage als SMD (Surface Mounted Device) ausgelegt sein.

Der Kanal ist typischerweise in Längsrichtung d.h. entlang der Kanalachse zur proximalen Verbinderkörperseite offen beziehungsweise mündet in diese, während ein distales Kanalende geschlossen ist bzw. im Verbinderkörper endet. Grundsätzlich kann der Kanal aber auch zur distalen Verbinderkörperseite hin offen und damit durchgängig sein.

In einer Ausführungsform können in einer Blickrichtung entlang der Kanalachse bzw. Verbinderkörperachse die lateralen Verbinderkörperseiten parallel zueinander und im Wesentlichen glatt sein. Dies ist etwa für einen quadratischen oder rechteckigen Querschnitt wie zuvor beschrieben gegeben. Eine solche Ausgestaltung ermöglicht die Anreihung einer Mehrzahl von Verbindern, wobei die Verbinderkörperachsen und damit die Kanalachsen der einzelnen Verbinder zu einander parallel sind. Optional können die lateralen Verbinderkörperseiten Ausricht- und/oder Koppelstrukturen zur gegenseitigen Ausrichtung und Verbindung mehrerer Verbinder bzw. Verbinderkörper umfassen. Solche Ausricht- und oder Koppelstrukturen können zum wechselseitigen Eingriff vorgesehenen konkave und konvexe Elemente, wie abragenden Nasen, Stifte, oder Ausbuchtungen als konvexe Elemente und entsprechende Ausnehmungen, Nuten, Vertiefungen oder Sacklöcher als konkave Elemente enthalten. Ebenfalls möglich sind etwa Nut- und Federelemente. Ferner kann eine solche Koppelstruktur Verriegelungselemente zum gegenseitigen Verriegeln, wie etwa Schnappelemente umfassen. Ferner können mehrere Verbinderkörper und/oder Deckelelemente miteinander einstückig gefertigt sein, und so einen elektrischen Mehrfachverbinder bilden. In einer solchen Ausgestaltung können die Verbinderkörperseitenwände der einzelnen Verbinder des Mehrfach-Verbinders integral miteinander geformt sein beziehungsweise in einander übergehen.

Das Deckelement kann ähnlich wie der Verbinderkörper eine proximale und eine distale Deckelelementseite aufweisen. Die Länge des Deckelements kann dabei zumindest im Wesentlichen der Länge des Verbinderkörpers entsprechen, bzw. der Abstand zwischen proximaler Deckelelementseite und distaler Deckelementseite kann dem Abstand zwischen proximaler Verbinderkörperseite und distaler Verbinderkörperseite entsprechen. Ebenso kann eine laterale Ausdehnung des Deckels im Wesentlichen der des Verbinderkörpers entsprechend. In einer Aufsicht können Verbinderkörper und Deckelelement zumindest im Wesentlichen kongruent sein.

Die Klemmstruktur erstreckt sich typischerweise entlang einer Deckelelementachse, welche in der geschlossenen Konfiguration parallel zur Kanalachse bzw. zur Verbinderkörperachse verlaufen kann. Die Klemmstruktur kann dabei durch ein oder mehrere konvexe Elemente wie Pins, Stifte, Nasen, und/oder bogenförmige Segmente wie weiter unten beschrieben gebildet werden, welche hintereinander und voneinander beabstandet oder unmittelbar aneinander angrenzend entlang der Deckelelementachse angeordnet sein können. In einer Ausgestaltung kann die Klemmstruktur durch einen von einer Deckelelementbasis abragenden Steg gebildet werden, der entlang der Deckelelementachse in seiner Höhe bzw. seinem Anstand zur Deckelelementbodenfläche variiert.

In einer Ausführungsform sind der Verbinderkörper und das Deckelelement einstückig geformt. In einer solchen Ausführungsform kann der elektrische Verbinder insgesamt als einstückiges Element, insbesondere einstückiges Spritzgusselement mit einer partiellen Metallisierung für das elektrische Anschlusselement, realisiert sein. Alternativ kann das Deckelelement aber auch als separates Bauteil realisiert sein.

Grundsätzlich eignen sich für das Deckelelement die gleichen Materialien und Fertigungsverfahren wie für den Verbinderkörper. Das Deckelelement besteht typischerweise ebenso wie der Verbinderkörper aus einem elektrisch isolierenden Material.

In einer Ausführungsform sind der Verbinderkörper und das Deckelelement mittels eines Scharniers verbunden, wobei das Scharnier die distale Verbinderkörperseite und eine distale Deckelelementseite schwenkbar verbindet. Bei einer einstückigen Ausgestaltung von Verbinderkörper und Deckelelement kann das Scharnier insbesondere als Film- oder Folienscharnier realisiert sein. In einer alternativen Ausgestaltung kann das Scharnier aber auch zweiteilig gestaltet sein, wobei jeweils ein Scharnierteil Teil des Verbinderkörpers bzw. des Deckelelements ist und mit diesem jeweils einstückig geformt bzw. angeformt sein kann.

Die Scharnierachse verläuft typischerweise quer zum Kanal beziehungsweise entlang der lateralen Richtung. Bei einer solchen Ausgestaltung sind der Verbinderkörper und das Deckelelement an ihren jeweiligen distalen Seiten in der geöffneten Konfiguration verbunden und öffnen sich von dort aus zu ihren entgegengesetzten proximalen Seiten hin, so dass das Deckelelement schräg vom Verbinderkörper abragt. Beim Überführen in die geschlossene Konfiguration wird das Deckelelement um die Scharnierachse bezüglich des Verbinderkörpers geschwenkt. In der geschlossenen Konfiguration als Endzustand kann ein die Klemmstruktur ganz oder teilweise umgebender peripherer Bereich des Deckelementes auf der Verbinderkörperoberseite aufliegen.

In einer Ausführungsform umfasst der elektrische Verbinder eine Rastvorrichtung. Die Rastvorrichtung umfasst dabei eine am Verbinderkörper angeordnete verbinderkörperseitige Raststruktur eine am Deckelement angeordnete deckelementseitige Raststruktur. Die verbinderkörperseitige und die deckelementseitige Raststruktur sind zur rastenden, insbesondere lösbar rastenden, Verriegelung von Verbinderkörper und Deckelelement durch formschlüssigen Eingriff von verbinderkörperseitiger und deckelelementseitiger Raststruktur ausgelegt.

Die verbinderkörperseitige Raststruktur und die deckelelementseitige Raststruktur können insbesondere jeweils in einem proximalen Bereich von Verbinderkörper bzw. Deckelelement angeordnet sein und können jeweils einstückig am Verbinderkörper beziehungsweise Deckelement angeformt sein. Eine der beiden Raststrukturen, insbesondere die deckelelementseitige Raststruktur, kann durch ein oder mehrere konvexe Strukturelemente, wie elastisch federnde Haken oder Nasen, Stifte oder Klinken realisiert sein. Entsprechend kann die andere Raststruktur, insbesondere die verbinderkörperseitige Raststruktur, durch korrespondierende konkave Strukturelemente, wie Ausnehmungen oder Durchbrüche, gebildet sein, in welche die konvexen Strukturelemente jeweils zum Verriegeln rastend eingreifen. Die verbinderkörperseitige Raststruktur kann etwa durch Ausnehmungen in den einander gegenüberliegenden Kanalseitenflächen angeordnet sein. Mindestens eine der Raststrukturen, etwa die deckelelementseitige Raststruktur, kann elastisch federnd sein, insbesondere in lateraler Richtung. Die verbinderkörperseitige Raststruktur kann in einer Ausführungsform beidseitig Kanalachse bzw. Verbinderkörperachse angeordnet sein bzw. jeweils einen Teil auf jeder Seite der Kanalachse bzw. Verbinderkörperachse haben. Entsprechend kann die deckelelementseitige Raststruktur beidseitig der Deckelelementachse angeordnet sein bzw. jeweils einen Teil auf jeder Seite der Deckelelementachse haben.

Die Rastvorrichtung verriegelt bzw. rastet ein, wenn das Deckelement beim Überführen von der geöffneten in die geschlossene Konfiguration seine Endstellung erreicht. Dadurch wird sichergestellt, dass die geschlossene Konfiguration beibehalten und die Klemmung des Einführabschnitts, insbesondere des unisolierten Drahtsegments beibehalten und das unisolierte Drahtsegment mit der Drahtkontaktfläche in sicherem elektrischen Kontakt gehalten wird. Die Rastvorrichtung verhindert ferner ein ungewolltes Öffnen des Verbinders aufgrund vom unisolierten Drahtsegment ausgeübter elastischer Kräfte wie weiter unten beschrieben.

Alternativ oder zusätzlich zu einer Rastvorrichtung des elektrischen Verbinders können der Verbinderkörper und das Deckelelement aber auch durch eine separate Vorrichtung, welche selbst nicht Teil des elektrischen Verbinders ist, etwa eine Klemmvorrichtung, in der geschlossenen Konfiguration gehalten werden.

Bei einer Ausführung mit Zugentlastung wie nachfolgend beschrieben kann sich die verbinderkörperseitige Raststruktur beispielsweise in distaler Richtung an die verbinderkörperseitiger Zugentlastungsstruktur anschliessen. Die deckelementseitige Raststruktur kann sich entsprechend in distaler Richtung an eine deckelementseitige Zugentlastungsstruktur anschliessen.

In einer Ausführungsform weist der elektrische Verbinder einen Drahtanschlag zur axialen Positionierung beziehungsweise Festlegung des Einführabschnitts des Drahtes bezüglich des elektrischen Verbinders auf. Der Drahtanschlag kann einen Anschlag für eine Stirnfläche einer Isolation des isolierten Drahtsegments am Übergang zum unisolierten Drahtsegment aufweisen oder durch einen solchen gebildet werden. Dabei weist der Drahtanschlag einen Drahtdurchlass auf, welcher eine Weite oder Ausdehnung in einer Richtung quer zur Drahtachse beziehungsweise in lateraler Richtung aufweist, die dem Durchmesser des unisolierten Drahtsegments, das heisst dem Draht ohne Isolation, entspricht oder vorteilhaft geringfügig grösser ist, aber geringer als der Durchmesser des isolierten Drahtsegments.

In einer Ausgestaltung ist der Drahtanschlag am Deckelement angeordnet und kann insbesondere Teil des Deckelements sein. Der Drahtanschlag kann mit einer deckelelementseitigen Raststruktur integral sein beziehungsweise eine deckelelementseitige Raststruktur kann zugleich als Drahtanschlag dienen. Hierzu kann die deckelementseitige Raststruktur jeweils ein Haken- oder Klingenelement beidseitig der Deckelelementachse aufweisen wie zuvor beschrieben. Ein lichter Abstand zwischen den Haken- oder Klinkenelementen ist dabei so bemessen, dass das unisolierte Drahtsegment zwischen ihnen hindurchpasst, während die Stirnfläche der Isolation an den Haken- oder Klinkenelementen, insbesondere an deren proximalen Stirnseiten, anschlägt. In weiteren Ausführungsformen kann der Drahtanschlag aber auch anderweitig realisiert sein, etwa durch entsprechend beabstandete Stege oder Stifte beidseitig der Deckelementachse. Zusätzlich oder alternativ kann eine Endaufnahme wie weiter unten Beschrieben als Drahtanschlag dienen.

Anspruchsgemäss sind der Kanalgrund und die Klemmstruktur dazu ausgelegt, das unisolierte Drahtsegment bei der Überführung von der geöffneten Konfiguration in die geschlossene Konfiguration zu deformieren. Hierzu kann die Kanaltiefe entlang der Kanalachse variieren beziehungsweise der Kanalgrund in Tiefenrichtung einen entlang der Kanalachse variierenden Abstand zur Kanaloberseite aufweisen. Hierdurch wird beim Überführen von der geöffneten in die geschlossene Konfiguration eine dem Kanalgrund entsprechende Deformation des unisolierten Drahtsegments bewirkt. Die Deformation erfolgt dabei in Richtung der Kanaltiefe beziehungsweise in einer durch Kanalachse und Deckelelmentachse festgelegten Ebene, zum Beispiel ohne oder mit geringfügiger beziehungsweise vernachlässigbarer Deformation in lateraler Richtung. Optional kann aber auch eine laterale Deformation erfolgen, um die Kontaktfläche zu erhöhen beziehungsweise die Kontaktsicherheit zu erhöhen. Eine solche Ausgestaltung ist vorteilhaft hinsichtlich der Kontaktsicherheit und der im Vergleich zu einer gradlinigen Erstreckung grösseren Berührfläche zwischen Draht und Drahtkontaktfläche.

Je nach Ausgestaltung und Materialeigenschaften des Drahtes kann die Deformation des Drahtes vollständig oder im Wesentlichen plastisch erfolgen, oder teilelastisch sein. Eine teilelastische Deformation bewirkt, dass der Draht beziehungsweise das unisolierte Drahtsegment in der geschlossenen Konfiguration eine elastische Restspannung aufweist. Diese erhöht den Andruck zwischen unisoliertem Drahtsegment einerseits und Drahtkontaktfläche andererseits. Die elastische Restspannung bewirkt ferner, dass der Kontakt auch dann erhalten bleibt, wenn nach längerer Zeit in der geschlossenen Konfiguration die Metallisierung der Drahtkontaktfläche aufgrund eines Fliessen des Materials des Verbinderkörpers degeneriert.

In einer Ausführungsform sind der Kanalgrund die Klemmstruktur dazu ausgelegt, im unisolierten Drahtsegment entlang der Kanalachse eine Anzahl bogenförmiger Abschnitte auszubilden. Hierzu kann insbesondere die Kanaltiefe entlang der Kanalachse abschnittsweise bogenförmig gestaltet. In einer speziellen Ausgestaltung können die bogenförmigen Abschnitte in einer Seitenansicht etwa kreisbogenförmig, beispielsweise halbkreisförmig, oder als Parabelbögen oder elliptisch gestaltet sein. In einer Ausgestaltung können zwei oder mehr derartiger bogenförmiger Abschnitte hintereinander angeordnet sein, wobei die bogenförmigen Abschnitte sich aneinander unmittelbar aneinander anschliessen oder zum Beispiel jeweils voneinander durch geradlinige beziehungsweise umgebogene Abschnitte getrennt sein.

In einer Ausführungsform weisst der Verbinderkörper eine Gegen-Klemmstruktur auf, wobei in der geschlossenen Konfiguration die Klemmstruktur und die Gegen-Klemmstruktur ineinander eingreifen und insbesondere das unisolierte Drahtsegment zwischen sich aufnehmen und klemmen. Die Gegen-Klemmstruktur wird dabei durch den Kanalgrund gebildet, wobei die Kanaltiefe entlang der Kanalachse variiert. Dabei wird während des Schliessens des Verbinders bzw. beim Überführen von der geöffneten Konfiguration in die geschlossene Konfiguration das unisolierte Drahtsegment entsprechend der Form von Klemmstruktur und Gegen-Klemmstruktur beziehungsweise Kanalgrund deformiert bzw. gebogen. In einer Ausgestaltung umfassen die Klemmstruktur und die Gegen-Klemmstruktur jeweils zueinander komplementäre bogenförmige Segmente wie zuvor beschrieben.

In einer Ausführungsform verläuft die die Drahtkontaktfläche mindestens teilweise auf dem Kanalgrund. Dabei ist der Kanalgrund entsprechend metallisiert. Bei einer solchen Ausgestaltung wird das unisolierte Drahtsegment in der geschlossenen Konfiguration durch das Deckelelement bzw. die Klemmstruktur sicher gegen die Drahtkontaktfläche gedrückt. Eine solche Ausgestaltung ist besonders vorteilhaft in Verbindung mit einer Vorrichtung wie zuvor beschrieben, welche im eingerasteten beziehungsweise verriegelten Zustand den Andruck zwischen unisolierten Drahtsegment und Drahtkontaktfläche sicherstellt. In weiteren Ausführungsformen kann die Drahtkontaktfläche ganz oder teilweise auf den Kanalseitenflächen verlaufen.

In einer Ausführungsform umfasst die Drahtkontaktfläche eine Mehrzahl von Kontaktflächensegmenten, welche durch einen Verbindungsleiter der Metallisierung elektrisch miteinander verbunden sind. Die Kontaktflächensegmente können dabei zum Beispiel auf bogenförmigen Segmenten, insbesondere bogenförmigen Segmenten einer Gegen-Klemmstruktur wie zuvor beschrieben, angeordnet sein. Der Verbindungsleiter kann selbst mehrteilig gestaltet sein und jeweils benachbarte bzw. entlang der Kanalachse hintereinander angeordnete Kontaktflächensegmente verbinden. Der Verbindungsleiter kann insbesondere an bzw. auf den Kanalseitenflächen und/oder an bzw. auf der Verbinderkörperoberseite verlaufen, beispielsweise beidseitig der Kanalachse bzw. Verbinderkörperachse.

In einer Ausführungsform weist der elektrische Verbinder eine Zugentlastung auf. Die Zugentlastungsstruktur kann insbesondere in einem proximalen Bereich angeordnet sein und ist dazu ausgelegt sein, in der geschlossenen Konfiguration das isolierte Drahtsegment zu klemmen. Dazu kann der Verbinderkörper eine verbinderkörperseitige Zugentlastungsstruktur und das Deckelelement eine deckelelementseitige Zugentlastungsstruktur aufweisen. Die verbinderkörperseitige und die deckelelementseitige Zugentlastungstruktur sind dazu ausgelegt, in der geschlossenen Konfiguration die Isolation des isolierten Drahtsegments zwischen sich aufzunehmen und zu klemmen. In einer Ausgestaltung ist sind die verbinderkörperseitige Zugentlastungsstruktur und die Deckelelementseitige Zugentlastungsstruktur zu einander komplementär und greifen in der geschlossenen Konfiguration ineinander, wobei der Draht bzw. das isolierte Drahtsegment beim Übergang von der geöffneten Konfiguration in die geschlossene Konfiguration entsprechend deformiert bzw. gebogen wird. Die verbinderkörperseitige und die deckelelementseitige Zugentlastungsstruktur können in grundsätzlich bekannter Weise ausgestaltet sein, beispielsweise jeweils in Form einer Wellenstruktur. In weiteren Ausgestaltungen sind die verbinderkörperseitige und die deckelelementseitige Klemmstruktur nicht streng komplementär zu einander, sondern jeweils z. B. durch eine Aufrauhung oder Anzahl von Noppen o.ä. gebildet, welche in die Isolation eingreifen.

In einer Ausführungsform mündet der Kanalgrund an einem distalen Kanalende in einer Endaufnahme. Die Endaufnahme ist dazu ausgelegt, einen sich vom Drahtende aus erstreckenden Endabschnitt des unisolierten Drahtsegments aufzunehmen, wobei die Endaufnahme in einem Winkel, insbesondere einem rechten Winkel, zur Kanalachse verläuft.

Die Endaufnahme kann durch eine Ausnehmung, Bohrung oder einen Kanal gebildet werden, welche(r) sich vom Kanalgrund am distalen Kanalende senkrecht oder schräg zur Verbinderkörperunterseite hin erstreckt. Zur Verbinderkörperunterseite hin kann die Endaufnahme offen oder geschlossen sein.

Im Zuge der Bereitstellung beziehungsweise Positionierung des Drahtes wird dabei in der geöffneten Konfiguration des elektrischen Verbinders der Endabschnitt mit dem Drahtende voran in die Endaufnahme eingeführt. Bei der Überführung in die geschlossene Konfiguration wird der Draht, insbesondere das unisolierte Drahtsegment, in den Kanal gedrückt und dabei am Übergang des Kanalgrunds zur Endaufnahme entsprechend dem Winkel zwischen Kanalachse und Endaufnahme umgebogen, zum Beispiel rechtwinklig umgebogen. Dieses Umbiegen verhindert ein Herausziehen des Einführabschnitts aus dem elektrischen Verbinder in der geschlossenen Konfiguration und dient damit als Auszugssicherung.

Ist die Endaufnahme zur Verbinderkörperunterseite hin geschlossen und zum Beispiel als Sacklock ausgebildet, kann der Grund oder Boden der Endaufnahme zugleich als Drahtanschlag dienen. In diesem Fall wird der Draht so weit in die Endaufnahme eingeführt, bis das Drahtende auf dem Grund beziehungsweise Boden des Sacklochs anschlägt. Gleiches kann bei einer sich grundsätzlich bis zur Verbinderkörperunterseite erstreckenden Endaufnahme durch einen Absatz beziehungsweise eine Schulter erreicht werden.

In einer Ausführungsform verbindet die Metallisierung die Drahtkontaktfläche und die Anschlussfläche durch einen Durchbruch des Verbinderkörpers hindurch elektrisch. In einer solchen Ausgestaltung bedeckt die Metallisierung eine oder mehrere Innenwände des Durchbruchs ganz oder teilweise. Der Durchbruch kann sich in der Verbinderkörperbasis vom Kanalgrund zur Verbinderkörperunterseite erstrecken. Alternativ oder zusätzlich kann der die Drahtkontaktfläche und die Anschlussfläche verbindende Teil der Metallisierung auch aussen bzw. auf einer äusseren Oberfläche des Verbinderkörpers verlaufen.

In einer Ausführungsform weist der Verbinderkörper eine Anschlussstruktur auf, wobei die Anschlussfläche mindestens teilweise an der Anschlussstruktur angeordnet ist. Die Anschlussstruktur kann insbesondere durch einen oder mehrere konvexe Elemente, wie Anschlussstifte oder Anschlusszapfen gebildet werden. Anschlussstifte oder Anschlusszapfen können beispielsweise an der ansonsten im Wesentlichen ebenen Verbinderkörperunterseite angeordnet sein und von dieser abragen. Bei der Montage des elektrischen Verbinders können die Anschlussstifte in jeweils eine entsprechende Bohrung oder Vertiefung eingesetzt werden. Anstatt oder zusätzlich zur Verbinderkörperunterseite kann die Anschlussstruktur aber auch etwa an einer oder beiden lateralen Verbinderkörperseite angeordnet sein.

In einer Ausführungsform können Positionier- und Verbindungsstrukturen in Form konvexer bzw. abragenden Positionierelemente wie Positionierpins, Positionierstifte, Positionierzapfen oder Positionierstege oder Positionierrippen, vorgesehen sein. In einer Ausführungsform ist eine Anzahl von Positionierelementen vorgesehen, welche sich entlang der bzw. parallel zur Verbinderkörperachse bzw. Kanalachse erstrecken und von der Verbinderkörperunterseite abragen. Bei der Montage können sie eine definierte Richtung der Verbinder- bzw. Kanalachse sicherstellen. In einer speziellen Ausgestaltung kann ein oder können mehrere Positionierelement zugleich als Anschlussstruktur wie oben beschrieben dienen. Sowohl für eine Anschlussstruktur wie auch für Positionierelemente insgesamt gilt, dass diese optional auch durch ganz oder teilweise durch negative Merkmale, wie Vertiefungen und Ausnehmungen gebildet werden können, in welche bei der Montage entsprechende konvexe Gegenelemente, wie Positionierstifte, oder Positionierstege oder Positionierrippen oder Positionierzapfen eingreifen.

In einer Ausführungsform weist das Deckelelement Führungselemente auf, wobei die Führungselemente in der geschlossenen Konfiguration von der Verbinderkörperoberseite her beidseitig der Kanalachse in den Verbinderkörper hineinragen.

Führungselemente können paarweise beidseitig und symmetrisch zur Deckelelementachse angeordnet sein und eine Anzahl von Führungselementen kann entlang der Deckelelementachse hintereinander angeordnet und zu einander optional beabstandet sein. Der lichte Abstand beziehungsweise Abstand in lateraler Richtung bei einem Paar von Führungselementen ist dabei jeweils so bemessen, dass er dem Drahtdurchmesser entspricht bzw. geringfügig grösser ist, so dass der Draht mit geringem Spiel zwischen ihnen Verlaufen kann. Die Führungselemente können insbesondere entlang der Deckelelementachse in einem Bereich angeordnet sein, welcher in der geschlossenen Konfiguration dem unisolierte Drahtsegment entspricht beziehungsweise können zur Führung des unisolierten Drahtsegments ausgelegt sein. Durch die Führungselemente wird sichergestellt, dass der Draht bzw. sein Einführabschnitt bei der Überführung von der geöffneten Konfiguration in die geschlossene Konfiguration in einer Ebene geführt wird bzw. nicht seitlich, d. h. quer zur Kanalachse ausbricht.

Die Führungselemente können, wie zuvor für die Klemmstruktur beschrieben, von der Deckelelementbasis abragen und beispielsweise als Stifte, Stege oder Zungen geformt sein. Die Führungselemente können in lateraler Richtung paarweise beidseitig der Klemmstruktur angeordnet sein.

Der Verbinderkörper kann zur Aufnahme der Führungselemente entsprechende korrespondierende konkave Führungselementaufnahmen, wie Ausnehmungen und/oder Aufweitungen bzw. Rücksprünge der Kanalseitenflächen aufweisen, in welche die Führungselemente beim Überführen von der geöffneten in die geschlossene Konfiguration eingreifen.

Die Führungselemente können ferner weiter von der Deckelelementbasis abragen als die Klemmstruktur. Auf diese Weise kommen sie bei der Überführung von der geöffneten in die geschlossene Konfiguration als erstes mit ihren Führungselementaufnahmen in Eingriff und stellen so eine definierte Bewegung des Deckelementes sicher und wirken beispielsweise einem Verklemmen, Verkippen oder Verkanten entgegen. Je nach Ausgestaltung kann diese Funktion zusätzlich oder alternativ zur Führung des Drahtes beziehungsweise seines Einführabschnitts gegeben sein.

In einer Ausführungsform können Elemente einer Raststruktur wie zuvor beschrieben als Führungselemente und Führungselementaufnahmen dienen.

In einer Ausführungsform weist der elektrische Verbinder eine Abisoliervorrichtung, insbesondere eine Abisolierklinge, auf. Eine Abisolierklinge kann etwa am Deckelelement einstückig angeformt sein beziehungsweise einen Teil des Deckelements bilden. Die Abisolierklinge kann etwa durch einen Grat oder eine entsprechend gestaltete scharfe Kante der deckelelementseitigen Raststruktur wie zuvor beschrieben, realisiert sein. Eine solche Abisoliervorrichtung dient dem hier typischerweise manuellen Abisolieren des Drahtes beziehungsweise dem Entfernen der Isolation im Bereich des abisolierten Drahtsegments. Grundsätzlich kann eine Abisoliervorrichtung aber auch am Verbinderkörper angeformt sein beziehungsweise einen Teil des Verbinderkörpers bilden. Die Integration einer Abisoliervorrichtung in den elektrischen Verbinder hat dabei den Vorteil, dass kein separates Werkzeug zum Abisolieren bereitgestellt beziehungsweise mitgeführt werden muss, was insbesondere im Feldeinsatz vorteilhaft ist.

### KURZER FIGURENBESCHRIEB

Es zeigen
- Fig. 1: eine perspektivische Ansicht eines beispielhaften offenbarungsgemässen elektrischen Verbinders in geöffneter Konfiguration gemeinsam mit einem Draht in einem Ausgangszustand im Längsschnitt;
- Fig. 2: eine zu Figur 1 korrespondierende Darstellung mit ungeschnittenem elektrische Verbinder;
- Fig. 3: eine zu Figur 2 korrespondierende distale Detailansicht;
- Fig. 4: den elektrischen Verbinder mit Draht gemäss Figur 1 in einem Zwischenzustand bei der Überführung von der geöffneten Konfiguration in die geschlossene Konfiguration;
- Fig. 5: den elektrischen Verbinder mit Draht gemäss Figur 1 in einem Endzustand nach Erreichen der geschlossenen Konfiguration;
- Fig. 6: den elektrischen Verbinder und Draht gemäss Figur 1 in der geschlossenen Konfiguration in perspektivischer Ansicht als Explosionsdarstellung;
- Fig. 7: eine zu Figur 6 korrespondierende Seitenansicht.

### AUSFÜHRUNGSBEISPIELE

Nachfolgend werden beispielhafte Ausführungsformen der Erfindung mit zusätzlichem Bezug auf die Figuren näher beschrieben. Dabei sind aus Gründen der Übersicht nicht alle Merkmale in allen Figuren mit Bezugszeichen versehen. Ebenso sind mehrfach vorhandene gleiche beziehungsweise korrespondierende Merkmale nicht zwingend jeweils einzeln mit Bezugszeichen versehen.

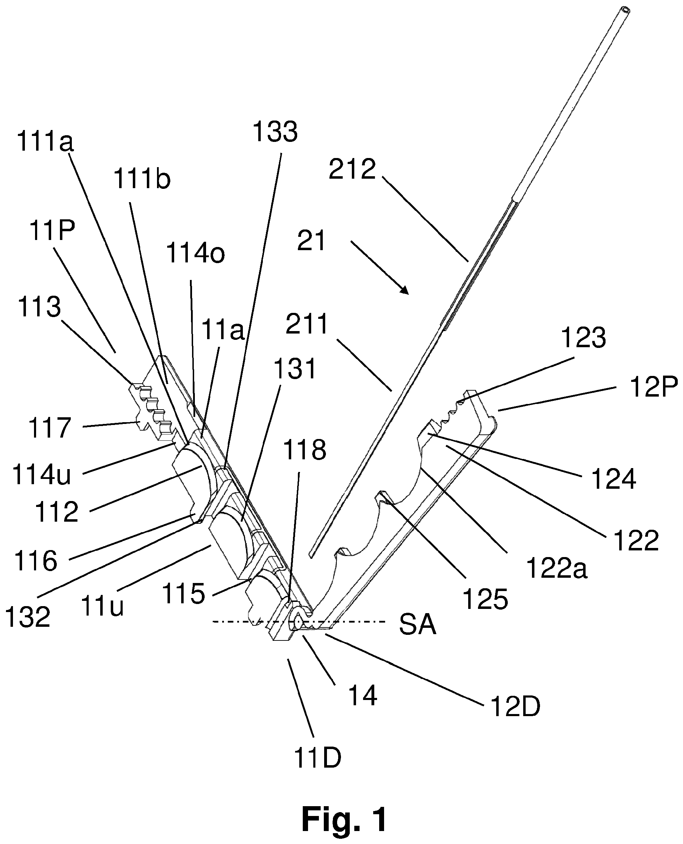

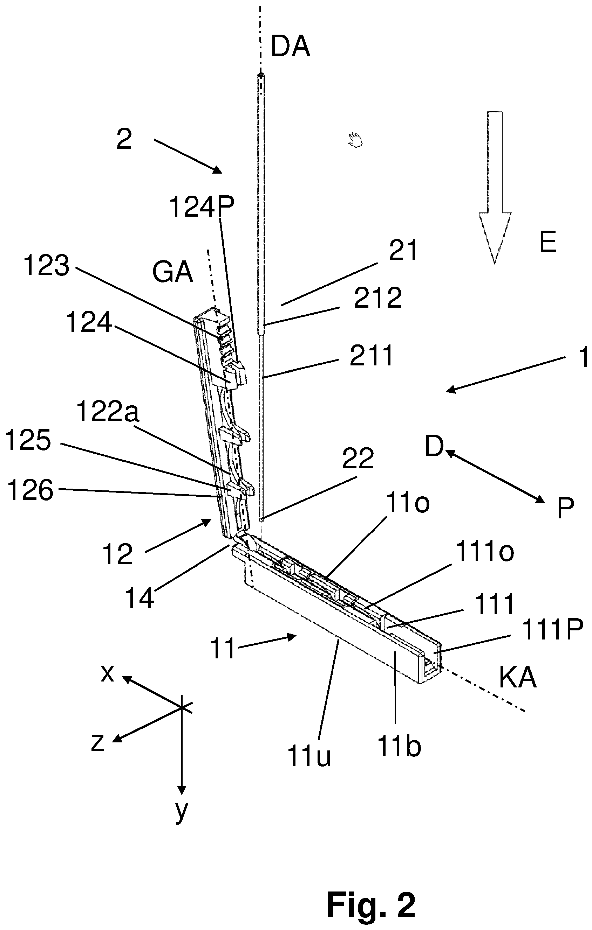

Eine proximale und eine distale Richtung sind mit P bzw. D bezeichnet. Zusätzlich ist ein kartesisches Koordinatensystem mit Koordinatenachsen x, y, z **(****Figur 2****)** vorgesehen, wobei eine Richtung von proximal nach distal beispielhaft der positiven x-Richtung entspricht. Eine Scharnierachse ist mit SA bezeichnet **(****Figur 1****),** wobei ihre Richtung beispielhaft der Richtung der z-Achse entspricht bzw. zu ihr parallel ist und zugleich die laterale Richtung definiert. Eine Kanalachse ist mit KA eine Deckelelementachse mit GA und eine Drahtachse mit DA bezeichnet (jeweils **Figur 2**). In der gezeigten Darstellung bezeichnet ferner die y-Achse des Koordinatensystems die Tiefenrichtung.

Der Aufbau eines beispielhaften offenbarungsgemäss elektrische Verbinders 1 wird nachfolgend zunächst insbesondere anhand der **Figuren 1****,** **2** beschrieben, wobei zusätzlich ein Abschnitt eines Drahtes 2 mit einem Einführabschnitt 21 dargestellt ist. Der langestreckte Verbinderkörper 11 erstreckt sich von einer proximalen Verbinderkörperseite 11P in distaler Richtung zu einer distale Verbinderkörperseite 11D. Der elektrische Verbinder 1 ist beispielhaft spiegelsymmetrisch, wobei eine Kanalachse KA entsprechende Verbinderkörperachse (nicht separat eingezeichnet) in der Spiegelebene läuft, welche senkrecht zur lateralen Richtung steht. Ferner verläuft die Spiegeleben durch die Deckelelementachse GA eines Deckelelements 12.

In einer Seitenansicht weist der Verbinderkörper 11 beispielhaft eine im wesentlichen rechteckige Gestalt auf. Eine Frontansicht entlang der Kanalachse KA ist beispielhaft ebenfalls im Wesentlichen rechteckig oder quadratisch, so dass sich insgesamt eine langgestreckte quaderförmige Gestalt ergibt. Andere Ausgestaltungen sind ebenfalls möglich.

Dabei weist der Verbinderkörper 11 eine im Wesentlichen glatte beziehungsweise ebene Verbinderkörperunterseite 11u und eine hierzu parallele Verbinderkörperoberseite 11o sowie zueinander parallele laterale Verbinderkörperseiten 11b auf. Die lateralen Verbinderkörperseiten 11b bzw. ihre Aussenflächen sind im gezeigten Beispiel ebenfalls glatt bzw. eben, so dass sich bei Bedarf eine Mehrzahl von elektrische Verbindern 1 bzw. Verbinderkörpern 11 Seite an Seite nebeneinanderreihen lassen.

Ein Kanal 111 erstreckt sich von der Verbinderkörperoberseite 11o aus in Tiefenrichtung in Richtung der Verbinderkörperunterseite 11u in den Verbinderkörper 11 hinein. Der Kanal weist eine offene Kanaloberseite 111o auf, welche zum Einlegen des Drahtes 2 bzw. seines Einführabschnitts 21 dient wie weiter unten beschrieben. Seitlich wird der Kanal 111 durch zwei Kanalseitenflächen 111b begrenzt. Der Kanal 111 erstreckt sich entlang einer Kanalachse KA, welche im gezeigten Beispiel mit der Verbinderkörperachse zusammenfällt. Der Kanal besitzt ferner einen Kanalgrund 111a, welcher zwischen den Kanalseitenflächen 111b angeordnet ist und diese verbindet. Ein senkrechter Abstand von der offenen Kanaloberseite 111o zum Kanalgrund 111a gibt eine Kanaltiefe an, welche im gezeigten Beispiel entlang der Kanalachse KA variiert wie weiter unten beschrieben. Ein lateraler Abstand quer zur Kanalachse KA entspricht der Kanalbreite, welche im gezeigten Beispiel ebenfalls entlang der Kanalachse KA variiert. Ferner ist der Kanalgrund 111a im gezeigten Beispiel entlang der Kanalachse KA nicht durchgängig, sondern weist Unterbrechungen bzw. Öffnungen zur Verbinderkörperunterseite 11u auf. Die Kanalseitenflächen 111b ergeben gemeinsam mit dem Kanalgrund 111a einen im Wesentlichen U-förmigen Kanalquerschnitt.

An einem distalen Kanalende mündet der Kanalgrund 111a in ein sich in Richtung der Verbinderkörperunterseite 11u erstreckendes Sackloch 118 als Endaufnahme und Drahtanschlag. Das Sackloch 118 erstreckt sich hier beispielhaft vom Kanalgrund 111a aus senkrecht zur Kanalachse KA in Richtung der Verbinderkörperunterseite 11u hin. Alternativ zu einem Sacklock kann auch ein Durchgangsloch vorgesehen sein.

Ein Deckelelement 12 des elektrische Verbinders 1 weist in der gezeigten Ausführungsform eine Deckelelementbasis 126 in Form einer flachen rechteckigen Scheibe bzw. eines Deckels auf. Eine Aufsicht des Deckelelements 12 korrespondiert beispielhaft im Wesentlichen mit der Aufsicht des Verbinderkörpers 11. Das Deckelelement 12 erstreckt sich von einer proximalen Deckelelementseite 12P entlang einer Deckelelementachse GA zu einer distalen Deckelelementseite 12D.

Der Verbinderkörper 11 sowie das Deckelelement 12 sind in der gezeigten Ausführungsform an ihren jeweiligen distalen Seiten 11D, 12D durch ein Scharnier 14 verbunden, wobei die Scharnierachse SA in lateraler Richtung verläuft. Das Deckelelement 12 kann gegenüber dem Verbinderkörper 11 um die Scharnierachse geschwenkt werden.

Der Verbinderkörper 11 und das Deckelelement 12 sind beispielhaft als zwei separate Komponenten ausgeführt, wobei der Verbinderkörper 11 und das Deckelelement 12 jeweils ein typischerweise spritzgegossenes Kunststoffteil sind. Ein Scharnierteil des Scharniers 14 ist dabei integral mit dem Verbinderkörper 11 und das andere Scharnierteil mit dem Deckelelement 12 ausgeführt. Grundsätzlich können Verbinderkörper 11 und Deckelelement 12 aber auch gemeinsam mit dem Scharnier 14 einstückig ausgeführt werden. In diesem Fall ist das Scharnier 14 beispielsweise als Film- oder Folienscharnier realisiert. In einer alternativen Ausgestaltung können Verbinderkörper 11 und Deckelelement 12 auch separate Teile ohne Scharnier sein, wobei das Deckelelement zur Überführung von der geöffneten in die geschlossene Konfiguration beispielsweise auf den Verbinderkörper aufgesetzt wird.

Das Deckelelement weist eine Klemmstruktur mit beispielhaft drei bogenförmigen Segmenten 122a auf, welche entlang der Deckelelementachse GA hintereinander angeordnet und gemeinsam als Steg 122 ausgebildet sind. Die Stegbreite quer zur Kanalachse beziehungsweise in lateraler Richtung ist dabei geringfügig schmaler als die Kanalbreite, so dass der Steg 122 in den Kanal 111 von der offenen Kanaloberseite 111o her eintauchen kann. Der Verbinderkörper 11 weist entlang der Verbinderkörperachse bzw. Kanalachse KA eine Gegen-Klemmstruktur auf, welche zu jedem bogenförmigen Segment 122a der Klemmstruktur ein korrespondierendes komplementäres Element in Form eines bogenförmigen Segments 112 umfasst. Dabei bilden die bogenförmigen Segmente 112 jeweils einen Teil des Kanalgrunds 1 1 1a.

In der gezeigten Ausgestaltung treffen die bogenförmigen Segmente 112 schräg auf die Kanalseitenflächen 111b, so dass der Kanalgrund 111a im Bereich der bogenförmigen Segmente 112 einen V-förmigen Querschnitt aufweist.

Entlang der Deckelelementachse GA zwischen den bogenförmigen Segmentenen1 22a beziehungsweise an der Grenze aufeinanderfolgender bogenförmiger Segmente 122a sind jeweils einander bezüglich der Deckelelementachse GA paarweise gegenüberliegende Führungselemente in Form von Führungszungen 125 mit beispielhaft rechteckigem Querschnitt angeordnet. Die Führungszungen 125 wie die Klemmstruktur beziehungsweise der die bogenförmigen Segmente 1 22a bildende Steg 122 ragen senkrecht von der Deckelelementbasis 126 ab. Die Führungszungen 125 ragen dabei weiter ab als die bogenförmigen Segmente 122a beziehungsweise ragen über diese hinaus.

Zur Aufnahme der Führungszungen 125 weist der Verbinderkörper 11 für jede Führungszunge 125 eine korrespondierende Führungselementaufnahme beziehungsweise Führungszungenaufnahme 115 auf. Die Führungszungenaufnahmen 115 sind durch in dieser Ausführungsform in Tiefenrichtung beziehungsweise zwischen der Verbinderkörperoberseite 1 1a und der Verbinderkörperunterseite 11u durchgängige Aufnahmeausnehmungen auf den Innenseiten der Verbinderkörperseitenwände 11a beziehungsweise lateralen Aufweitungen des Kanals 111 realisiert. Dadurch ist auch der Kanalgrund 111a entlang der Kanalachse KA jeweils zwischen den bogenförmigen Segmenten 112 der Gegen-Klemmstruktur unterbrochen.

Der elektrische Verbinder 1 weist ferner eine Rastvorrichtung auf. Die Rastvorrichtung umfasst eine deckelelementseitige Raststruktur auf, welche durch in lateraler Richtung beziehungsweise quer zur Deckelelementachse GA federnde Klinken 124 realisiert sind. Die federnden Klinken 124 ragen von der Deckelelementbasis 126 in ähnlicher Weise wie die Führungszungen 125 ab und sind wie diese paarweise beidseitig der Deckelelementachse GA angeordnet. Die Klinkenflächen der federnden Klingen 124 sind nach aussen beziehungsweise von der Deckelelementachse GA weg gerichtet. Die zueinander weisenden Innenseiten der federnden Klinken 124 weisen zueinander einen lichten Abstand derart auf, dass sie den unisolierten Draht beziehungsweise das unisolierte Drahtsegment 211 zwischen sich aufnehmen können, nicht aber das isolierte Drahtsegment 212, so dass sie zugleich als Drahtanschlag dienen können.

Zur Aufnahme der federnden Klinken 124 weist der Verbinderkörper 11 für jede der beiden federnden Klinken 124 eine obere Klinkenaufnahme 114o und eine untere Klinkenaufnahme 114u auf. Die oberen Klinkenaufnahmen 114o sind dabei zur Verbinderkörperoberseite 11o hin offen und die unter Klinkenaufnahmen 114u sind zur Verbinderkörperunterseite 11u hin offen, so dass der Kanalgrund 111a im Bereich der Klinkenaufnahmen 114o, 114u unterbrochen ist. Die obere und untere Klinkenaufnahme 114o, 114u sind dabei jeweils durch eine Ausnehmung auf den Innenseiten der Verbinderkörperseitenwänden 11a realisiert, wobei die obere Klinkenaufnahme 114o und die untere Klinkenaufnahme 114u zueinander jeweils nicht durchgängig sind. Die oberen und unteren Klinkenaufnahme 114o, 114u bilden gemeinsam eine verbinderkörperseitige Raststruktur. Soll der elektrische Verbinder 1 derart gestaltet werden, dass er von der geschlossenen wieder in die geöffnete Konfiguration überführbar ist, so können die federnden Klinken 124 von unten her beispielsweise durch ein Werkzeug wie eine entsprechend gestalte Zange in lateraler Richtung nach innen elastisch deformiert werden, so dass sie sich aus den unteren Klinkenaufnahmen 114u lösen lassen. Ferner können hierzu optional alternativ oder zusätzlich entsprechende Durchbrüche in den Verbinderkörperseitenwänden 11a vorgesehen sein.

Ferner weist der Verbinderkörper 11 eine Zugentlastung mit einer verbinderkörperseitige Zugentlastungsstruktur 113 einer hierzu komplementäre deckelelementseitigen Zugentlastungsstruktur 123 auf, welche in der geschossenen Konfiguration ineinandergreifen. Die verbinderkörperseitige Zugentlastungsstruktur 113 bildet dabei einen proximalen Teil des Kanalgrunds 111a. Die federnden Klinken sind in distaler Richtung in Anschluss die deckelelementseitige Zugentlastungsstruktur 123 angeordnet und die Klinkenaufnahmen 1 14o, 114u sind in distaler Richtung D in Anschluss an die verbinderkörperseitige Zugentlastungsstruktur 113 angeordnet.

Auf den Verbinderkörper 11 ist eine partielle Metallisierung 13 aufgebracht. Die Metallisierung 13 bedeckt dabei den Kanalgrund 111a insbesondere im Bereich der bodenförmigen Segmente 112 der Gegen-Klemmstruktur, wodurch gemeinsam eine Drahtkontaktfläche 131 gebildet wird. Die einzelnen Segmente beziehungsweise Abschnitte der Drahtkontaktfläche 131 (entsprechend den bogenförmigen Segmenten 112 der Gegen-Klemmstruktur) sind dabei über einen Verbindungsleiter 133 verbunden, der ebenfalls Teil der partiellen Metallisierung 13 bildet. Der Verbindungsleiter 133 ist in dieser Ausführungsform über die Kanalseitenflächen 111b und die Verbinderkörperoberseite 11o geführt.

Abragend von der Verbinderkörperunterseite 11u weist der Verbinderkörper 11 ferner eine Anzahl von exemplarisch drei entlang der Verbinderkörperachse angeordneter Positionierstiften 117 auf. Einer der Positionierstifte 117, beispielhaft der mittlere, dient in der gezeigten Ausführungsform zugleich als Anschlusstift 116. Hierfür ist die Metallisierung 13 über die Innenwand einer angrenzenden Führungszungenaufnahme 115 auf die Aussenfläche des Anschlussstiftes 116 geführt, wodurch die Metallisierung 113 eine Anschlussfläche 132 auf dem Anschlusstift 116 ausbildet. Bei Aufnahme der Positionierstifte 117 und insbesondere des Anschlusstift 116 in entsprechenden Bohrungen z. B. einer Leiterplatte oder einer Baugruppe kann die Anschlussfläche 132 z.B. durch Löten oder Klemmen des Anschlussstifts 116 elektrisch kontaktiert werden.

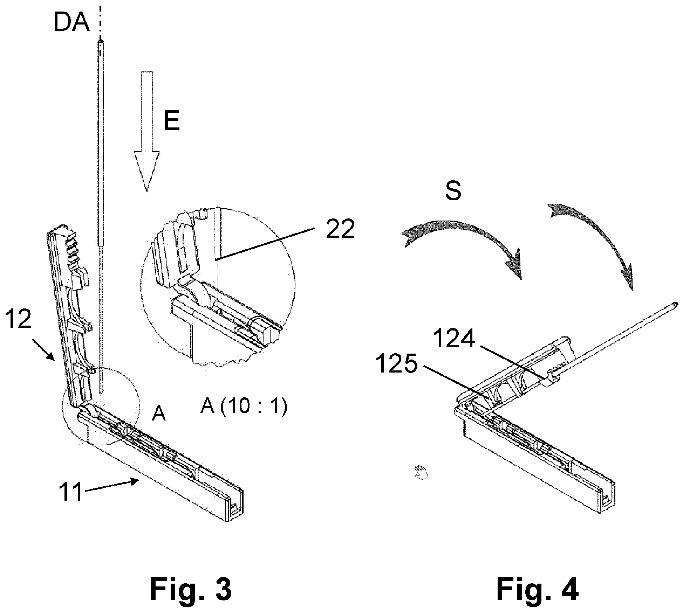

Nachfolgend wird mit zusätzlicher Bezugnahme auf die weiteren **Figuren 3, 4****,** **5, 6, 7** ein anspruchsgemässes Verfahren zum Anschliessen des Drahtes 2 erläutert. Der Einführabschnitt 21 des Drahtes 2weist dabei ein isoliertes Drahtsegment 112 und ein sich anschliessendes unisolierte Drahtsegment 211 auf, wobei das unisolierte Drahtsegment 211 mit einem Drahtende 22 als Stirnfläche abschliesst. Wenngleich nicht zwingend, wird der Draht 2 hier mit einem runden Querschnitt bzw. Rotationssymmetrie um die Drahtachse DA angenommen.

Wie in den **Figuren 1****,** **2****,** **3** gezeigt, wird der Draht 2 derart positioniert bzw. bereitgestellt, dass seien Drahtachse DA mit der Achse des Sacklochs 118 fluchtet und sein Endabschnitt 23 wird in der Einführrichtung E mit dem Drahtende 22 voran in das Sacklock 118 eingeführt, bis das Drahtende 22 auf dessen als Drahtanschlag dienenden Grund aufstösst.

Der elektrische Verbinder 1 befindet sich dabei in der geöffneten Konfiguration und der Draht 2 bzw. sein Einführabschnitt 21 erstreckt sich nach dem Einführen des Endabschnitts 23 in das Sackloch 118 im Wesentlichen senkrecht zur Verbinderkörperoberseite 11o.

Ferner werden der Draht 2 und das Deckelelement 12 so zueinander positioniert, dass das unisolierte Drahtsegment 211 jeweils zwischen den einander entlang der Deckelementachse GA einander gegenüberliegenden federnden Klinken 124 und Führungszungen 125 liegt.

Das Entfernen der Isolation im unisolierten Drahtsegment 211 kann vorgängig durch ein separates Werkzeug oder in den elektrischen Verbinder integrierte beziehungsweise angeformte Abisoliervorrichtung wie oben beschrieben erfolgen. Ferner kann der Draht bereits entsprechend konfektioniert bereitgestellt werden.

Anschliessend wird der elektrische Verbinder 1 von der geöffneten Konfiguration in die geschlossene Konfiguration überführt, was durch eine Schwenkbewegung des Deckelelements 12 um die Scharnierachse SA mit einer Schwenkrichtung S auf den Verbinderkörper 11 zu erfolgt **(****Figur 4****).** Das Drahtende 22 wird dabei im Sackloch 118 festgehalten bzw. fixiert und der Draht wird vom Deckelement 12 am Übergang zwischen Sackloch 118 und Kanalgrund 111a umgebogen.

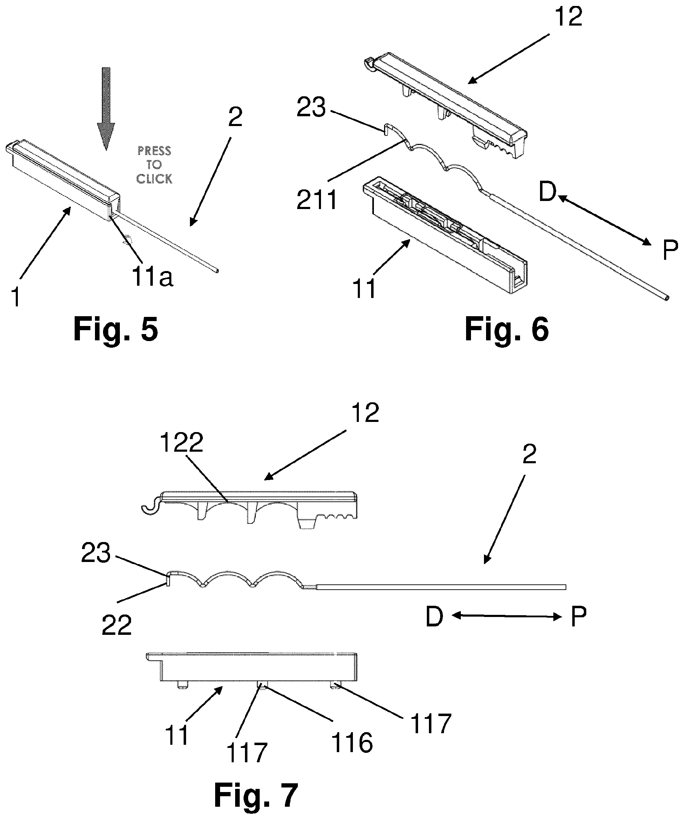

Bei weiterer Fortsetzung der Schwenkbewegung kommt das Deckelelement 12 schliesslich auf dem Verbinderkörper 11 bzw. seiner Verbinderkörperoberseite 11o zu liegen **(****Figur 5**). Dabei wird das unisolierte Drahtsegment 211 im Zuge der Schwenkbewegung zwischen den bogenförmigen Segmenten 122a der Klemmstruktur und den bogenförmigen Segmenten 112 der Gegen-Klemmstruktur deformiert, so dass sich im Bereich des unisolierte Drahtsegments 211 ein wellenförmiger Verlauf ergibt **(****Figuren 6, 7****).**

Ebenfalls im Zuge der Schwenkbewegung tauchen die Führungszungen 125 von der Verbinderkörperoberseite 11o her in die Führungszungenaufnahmen 115 und in einer letzten Phase kurz vor Erreichen der geschlossenen Konfiguration die federnden Klinken 124 zunächst in die jeweiligen oberen Klinkenaufnahmen 114o ein. Durch eine Kante am Übergang der oberen Klinkenaufnahmen 114o zum zwischen den oberen Klinkenaufnahmen 114 o und den unteren Klinkenaufnahmen 114u befindlichen Teil der Kanalseitenfläche 111b werden die federnden Klinken 124 zunächst lateral nach innen bzw. zur Deckelelementachse GA hin elastisch formiert. Beim Übergang in die jeweiligen unteren Klinkenaufnahme 114u federn die federnden Klinken 124 in lateraler Richtung zurück nach aussen, wobei jede federnde Klinke 124 in die zugehörige untere Klinkenaufnahme 114u einrastet, so dass das Deckelelement 12 mit dem Verbinderkörper 11 verriegelt wird. Das Einrasten beziehungsweise Verriegeln ist dabei bevorzugt mit einer hörbaren akustischen Rückmeldung, insbesondere einem Klicken verbunden, welches den Endzustand bzw. das Erreichen der geschlossenen Konfiguration markiert.

In diesem Zustand ist auch das isolierte Drahtsegment 212 zwischen der verbinderkörperseitigen Zugentlastungsstruktur 113 und deckelelementseitigen Zugentlastungsstruktur 123 aufgenommen und geklemmt und der der Einführabschnitt 21 des Drahtes 2 ist in den Kanal 111 vollständig eingelegt. Wie in **Figur 5** ersichtlich, ragt der Draht 2 an der proximalen Verbinderkörperseite 11P aus dem Kanal 111 heraus.

Aufgrund der Verriegelung von Verbinderkörper 11 und Deckelelement 12 wird das unisolierte Drahtsegment 211 zwischen den bogenförmigen Segmenten 122a der Klemmstruktur und den bogenförmigen Segmenten 112 der Gegen-Klemmstruktur bzw. dem Kanalgrund 111a fest geklemmt und so ein sicherer Andruck des unisolierten Drahtsegments 211 mit der Drahtkontaktfläche 131 sichergestellt.

In der geschlossenen Konfiguration des elektrischen Verbinders 1 dienen ferner die proximalen Stirnseiten 124P der federnden Klinken 124 als Drahtanschlag. Wenn anstelle des Sackloches 118 ein Durchgangsloch vorgesehen ist, dienen die Stirnseiten 124P als Drahtanschlag auch zur initialen Positionierung des Drahtes. Bei Vorhandensein des Sacklochs 118 kann optional auf einen Drahtanschlag durch die federnden Klinken 124 beziehungsweise ihre proximalen Stirnseiten verzichtet werden.

Der gesamte Ablauf kann von einem Anwender einhändig vorgenommen werden und ist dabei weitestgehend fehlersicher. Besonders vorteilhaft ist, dass die Überführung des elektrischen Verbinders von der geöffneten in die geschlossene Konfiguration und damit der Anschluss des Drahtes 2 mit einer einzigen Bewegung erfolgt, nämlich der Schwenkbewegung des Deckelements 12.

### BEZUGSZEICHEN

- 1: Elektrischer Verbinder
- 11: Verbinderkörper
- 11P: proximale Verbinderkörperseite
- 11D: distale Verbinderkörperseite
- 11a: Verbinderkörperseitenwand
- 11b: laterale Verbinderkörperseite
- 11o: Verbinderkörperoberseite
- 11u: Verbinderkörperunterseite
- 111: Kanal
- 111a: Kanalgrund
- 111P: proximales Kanalende
- 111a: Kanalgrund
- 111b: Kanalseitenfläche
- 111o: offene Kanaloberseite
- 112: bogenförmiges Segment (Gegen-Klemmstruktur)
- 113: verbinderkörperseitige Zugentlastungsstruktur
- 114o: obere Klinkenaufnahme
- 114u: untere Klinkenaufnahme
- 115: Führungszungenaufnahme
- 116: Anschlussstift
- 117: Positionierstift
- 118: Sackloch
- 12: Deckelelement
- 12P: proximale Deckelelementseite
- 12D: distale Deckelelementseite
- 122: Steg
- 122a: bogenförmiges Segment (Klemmstruktur)
- 123: deckelelementseitige Zugentlastungsstruktur
- 124: federnde Klinke (deckelelementseitige-Raststruktur)
- 124P: proximale Stirnseite (federnde Klinke)
- 125: Führungszunge
- 126: Deckelelementbasis
- 13: Metallisierung, elektrisches Anschlusselement
- 131: Drahtkontaktfläche
- 132: Anschlussfläche
- 133: Verbindungsleiter
- 14: Scharnier
- 2: Draht
- 21: Einführabschnitt
- 211: unisolierte Drahtsegment
- 212: isoliertes Drahtsegment
- 22: Drahtende
- 23: Endabschnitt
- E: Einführrichtung
- DA: Drahtachse
- GA: Deckelelementachse
- KA: Kanalachse
- SA: Scharnierachse (Querachse)
- P: proximale Richtung
- D: distale Richtung
- S: Schwenkrichtung
- x, y, z: Koordinatenachsen

## Patentansprüche

1. Elektrischer Verbinder (1) füreinen Draht (2) mit einem Drahtende (22),wo ein sich vom Drahtende (22) aus erstreckendes unisoliertes Drahtsegment (211) und einen sich an das unisolierte Drahtsegment (211) angrenzendes isoliertes Drahtsegment (212) gemeinsam einen Einführabschnitt (21) bilden, wobei der elektrische Verbinder (1) von einer geöffneten Konfiguration in eine geschlossene Konfiguration überführbar ist, wobei der elektrische Verbinder (1) umfasst:
a) einen Verbinderkörper (11) mit einer proximalen (11P) und einer distalen (11D) Verbinderkörperseite sowie einer Verbinderkörperoberseite (11o),
- wobei der Verbinderkörper (11) einen Kanal (111) zur Aufnahme des Einführabschnitts (21) aufweist,
- wobei der Kanal (111) sich im Verbinderkörper (11) entlang einer Kanalachse (KA) von einem proximalen Kanalende in distaler Richtung (D) erstreckt, wobei das proximale Kanalende (111P) in die proximale Verbinderkörperseite mündet, wobei der Kanal (111) eine zur Verbinderkörperoberseite (11o) hin offene Kanaloberseite (111o) und einen Kanalgrund (111a) aufweist,
- wobei der Verbinderkörper (11) aus elektrisch isolierendem Material geformt ist;
b) ein elektrisches Anschlusselement, wobei das elektrische Anschlusselementeine im Kanal (11) angeordnete Drahtkontaktfläche (131) zur Kontaktierung des unisolierten Drahtsegments (211) und eine aussen am Verbinderkörper (11) angeordnete Anschlussfläche (132) aufweist;
c) ein Deckelelement (12), wobei das Deckelelement (12) eine Klemmstruktur aufweist, wobei die Klemmstruktur dazu ausgelegt ist, in der geschlossenen Konfiguration den Einführabschnitt (12) zwischen Kanalgrund (111a) und Klemmstruktur zu klemmen und das unisolierte Drahtsegment (211) mit der Drahtkontaktfläche (131) in Kontakt zu halten,
**dadurch gekennzeichnet dass**
das elektrische Anschlusselement durch Metallisierung, insbesondere eine partielle Metallisierung (13), des Verbinderkörpers (11) gebildet wird,
die Klemmstruktur in der geöffneten Konfiguration nicht in den Kanal (111) hineinragt und in der geschlossenen Konfiguration von der offenen Kanaloberseite (111o) her in den Kanal (111) hineinragt, und
der Kanalgrund (11 1a) und die Klemmstruktur dazu ausgelegt sind, das unisolierte Drahtsegment (211) bei der Überführung von der geöffneten Konfiguration in die geschlossene Konfiguration zu deformieren.

2. Elektrischer Verbinder (1) gemäss Anspruch 1, wobei der Verbinderkörper (11) und das Deckelelement (12) einstückig geformt sind.

3. Elektrischer Verbinder (1) gemäss einem der vorhergehenden Ansprüche, wobei der Verbinderkörper (11) und das Deckelelement (12) mittels eines Scharniers (14) verbunden sind, wobei das Scharnier (14) die distale Verbinderkörperseite (11D) und eine distale Deckelelementseite (12D) schwenkbar verbindet und eine quer zum Kanal (111) orientierte Scharnierachse (SA) aufweist.

4. Elektrischer Verbinder (1) gemäss einem der vorhergehenden Ansprüche, der elektrische Verbinder eine Rastvorrichtung umfasst, wobei die Rastvorrichtung eine am Verbinderkörper (11) angeordnete verbinderkörperseitige Raststruktur und eine am Deckelement (12) angeordnete deckelementseitige Raststruktur umfasst, wobei die verbinderkörperseitige und die deckelementseitige Raststruktur zur rastenden, insbesondere lösbar rastenden, Verriegelung von Verbinderkörper (11) und Deckelelement (12) durch formschlüssigen Eingriff von verbinderkörperseitiger und Deckelelementseitiger Raststruktur ausgelegt sind.

5. Elektrischer Verbinder (1) gemäss einem der vorhergehenden Ansprüche, wobei der elektrische Verbinder (1) einen Drahtanschlag zur axialen Positionierung des Einführabschnitts bezüglich des elektrischen Verbinders aufweist.

6. Elektrischer Verbinder (1) gemäss einem der vorhergehenden Ansprüche, wobei der Kanalgrund (111a) und die Klemmstruktur dazu ausgelegt sind, im unisolierten Drahtsegment (211) entlang der Kanalachse eine Anzahl bogenförmiger Abschnitte auszubilden.

7. Elektrischer Verbinder (1) gemäss einem der vorhergehenden Ansprüche, wobei die Drahtkontaktfläche (131) mindestens teilweise auf dem Kanalgrund (111a) verläuft.

8. Elektrischer Verbinder (1) gemäss einem der vorhergehenden Ansprüche, wobei die Drahtkontaktfläche (131) eine Mehrzahl von Kontaktflächensegmenten umfasst, welche durch einen Verbindungsleiter (133) der Metallisierung (13) elektrisch miteinander verbunden sind.

9. Elektrischer Verbinder (1) gemäss einem der vorhergehenden Ansprüche, wobei der elektrische Verbinder eine Zugentlastung aufweist.

10. Elektrischer Verbinder (1) gemäss einem der vorhergehenden Ansprüche, wobei der Kanalgrund (111a) an einem distalen Kanalende in eine Endaufnahme, wobei die Endaufnahme dazu ausgelegt ist, einen sich vom Drahtende aus erstreckenden Endabschnitt (23) des unisolierten Drahtsegments (211) aufzunehmen, wobei die Endaufnahme in einem Winkel, insbesondere einem rechten Winkel, zur Kanalachse verläuft.

11. Elektrischer Verbinder (1) gemäss einem der vorhergehenden Ansprüche, wobei Metallisierung (13) die Drahtkontaktfläche (131) und die Anschlussfläche (132) durch einen Durchbruch oder mehrere Durchbrüche des Verbinderkörpers (11) hindurch elektrisch verbindet.

12. Elektrischer Verbinder (1) gemäss einem der vorhergehenden Ansprüche, wobei der Verbinderkörper (11) eine Anschlussstruktur, insbesondere mindestens einen abragenden Anschlusstift (116) aufweist, wobei die Anschlussfläche (132) mindestens teilweise an der Anschlussstruktur angeordnet ist.

13. Elektrischer Verbinder (1) gemäss einem der vorhergehenden Ansprüche, wobei das Deckelelement (12) Führungselemente aufweist, wobei die Führungselemente in der geschlossenen Konfiguration von der Verbinderkörperoberseite (11o) her beidseitig der Kanalachse (KA) in den Verbinderkörper (11) hineinragen.

14. Verbinder-Draht-Anordnung, umfassend einen elektrischen Verbinder (1) gemäss einem der vorhergehenden Ansprüche sowie einen Draht (2) mit einem Drahtende (22), wo ein sich vom Drahtende (22) aus erstreckendes unisoliertes Drahtsegment (211) und einen sich an das unisolierte Drahtsegment (211) angrenzendes isoliertes Drahtsegment (212) gemeinsam einen Einführabschnitt (12) bilden, wobei der Einführabschnitt (12) im Kanal (111) aufgenommen ist.

15. Verfahren zum Anschliessen eines Drahtes, das Verfahren umfassend:
- Bereitstellen eines elektrischen Verbinders gemäss einem der Ansprüche 1 bis 13 in geöffneter Konfiguration sowie eines Drahtes (2) mit einem Drahtende (22), wo ein sich vom Drahtende (22) aus erstreckendes unisoliertes Drahtsegment (211) und einen sich an das unisolierte Drahtsegment (211) angrenzendes isoliertes Drahtsegment (212) gemeinsam einen Einführabschnitt (12) bilden;
- Überführen des elektrischen Verbinders (1) von der geöffneten Konfiguration in die geschlossene Konfiguration, wodurch der Einführabschnitt (12) in den Kanal eingelegt und zwischen Klemmstruktur und Kanalgrund geklemmt und das unisolierte Drahtsegment (211) deformiert und mit der Drahtkontaktfläche (131) in Kontakt gebracht wird.

## Claims

1. An electrical connector (1) for a wire (2) having a wire end (22), wherein an uninsulated wire segment (211) extending from the wire end (22) and an insulated wire segment (212) adjacent to the uninsulated wire segment (211) together form an insertion section (21), wherein the electrical connector (1) is convertible from an open configuration to a closed configuration, wherein the electrical connector (1) comprises:
a) a connector body (11) with a proximal (11P) and a distal (11D) connector body side and a connector body top (11o),
- wherein the connector body (11) has a channel (111) for receiving the insertion section (21),
- wherein the channel (111) extends in the connector body (11) along a channel axis (KA) from a proximal channel end in a distal direction (D), wherein the proximal channel end (111P) opens into the proximal connector body side, wherein the channel (111) has a channel top (111o) open toward the connector body top (11o) and a channel base (111a),
- wherein the connector body (11) is formed from electrically insulating material;
b) an electrical connection element, wherein the electrical connection element has a wire contact surface (131) arranged in the channel (111) for contacting the uninsulated wire segment (211) and a connection surface (132) arranged on the outside of the connector body (11);
c) a cover element (12), wherein the cover element (12) has a clamping structure, wherein the clamping structure is adapted, in the closed configuration, to clamp the insertion section (12) between the channel base (111a) and the clamping structure and to hold the uninsulated wire segment (211) in contact with the wire contact surface (131),
**characterized in that**
the electrical connection element is formed by metallization, in particular partial metallization (13), of the connector body (11),
the clamping structure does not protrude into the channel (111) in the open configuration and protrudes into the channel (111) from the open channel top (111o) in the closed configuration, and
the channel base (111a) and the clamping structure are designed to deform the uninsulated wire segment (211) during the transition from the open configuration to the closed configuration.

2. Electrical connector (1) according to claim 1, wherein the connector body (11) and the cover element (12) are integrally molded.

3. Electrical connector (1) according to one of the preceding claims, wherein the connector body (11) and the cover element (12) are connected by means of a hinge (14), wherein the hinge (14) pivotally connects the distal connector body side (11D) and a distal cover element side (12D) and has a hinge axis (SA) oriented transversely to the channel (111).

4. Electrical connector (1) according to one of the preceding claims, wherein the electrical connector comprises a latching device, wherein the latching device comprises a connector body-side latching structure arranged on the connector body (11) and a cover element-side latching structure arranged on the cover element (12), wherein the connector body-side and cover element-side latching structures comprise latching elements for latching, in particular releasable latching, of the connector body (11) and the cover element (12) by form-fit engagement of the connector body-side and cover element-side latching structures.

5. Electrical connector (1) according to one of the preceding claims, wherein the electrical connector (1) has a wire stop for axially positioning the insertion section relative to the electrical connector.

6. Electrical connector (1) according to one of the preceding claims, wherein the channel base (111a) and the clamping structure are designed to form a number of arcuate sections in the uninsulated wire segment (211) along the channel axis.

7. Electrical connector (1) according to one of the preceding claims, wherein the wire contact surface (131) extends at least partially on the channel base (111a).

8. Electrical connector (1) according to one of the preceding claims, wherein the wire contact surface (131) comprises a plurality of contact surface segments which are electrically connected to each other by a connecting conductor (133) of the metallization (13).

9. Electrical connector (1) according to one of the preceding claims, wherein the electrical connector has a strain relief.

10. Electrical connector (1) according to one of the preceding claims, wherein the channel base (11 1a) at a distal channel end extends into an end receptacle, wherein the end receptacle is designed to receive an end portion (23) of the uninsulated wire segment (211) extending from the wire end, wherein the end receptacle extends at an angle, in particular a right angle, to the channel axis.

11. Electrical connector (1) according to one of the preceding claims, wherein metallization (13) electrically connects the wire contact surface (131) and the connection surface (132)through one or more openings in the connector body (11).

12. Electrical connector (1) according to one of the preceding claims, wherein the connector body (11) has a connection structure, in particular at least one protruding connection pin (116), wherein the connection surface (132) is arranged at least partially on the connection structure.

13. Electrical connector (1) according to one of the preceding claims, wherein the cover element (12) has guide elements, wherein in the closed configuration the guide elements protrude into the connector body (11) from the connector body top (11o) on both sides of the channel axis (KA).

14. Connector-wire arrangement comprising an electrical connector (1) according to one of the preceding claims and a wire (2) with a wire end (22), wherein an uninsulated wire segment (211) extending from the wire end (22) and an insulated wire segment (212) adjacent to the uninsulated wire segment (211) together form an insertion section (12), wherein the insertion section (12) is received in the channel (111).

15. Method for connecting a wire, the method comprising:
- providing an electrical connector according to one of claims 1 to 13 in an open configuration and a wire (2) with a wire end (22), wherein an uninsulated wire segment (211) extending from the wire end (22) and an insulated wire segment (212) adjacent to the uninsulated wire segment (211) together form an insertion section (12);
- transitioning the electrical connector (1) from the open configuration to the closed configuration, whereby the insertion section (12) is inserted into the channel and clamped between the clamping structure and the channel base, and the uninsulated wire segment (211) is deformed and brought into contact with the wire contact surface (131).

## Revendications

1. Connecteur électrique (1) pour un fil (2) comportant une extrémité de fil (22), dans lequel un segment de fil non isolé (211) s'étendant à partir de l'extrémité de fil (22) et un segment de fil isolé (212) adjacent au segment de fil non isolé (211) forment ensemble une section d'insertion (21), le connecteur électrique (1) pouvant être transféré d'une configuration ouverte à une configuration fermée, le connecteur électrique (1) comprenant :
a) un corps de connecteur (11) avec un côté proximal (11P) et un côté distal (11D) du corps de connecteur ainsi qu'un côté supérieur (11o) du corps de connecteur,
- le corps de connecteur (11) comportant un canal (111) destiné à recevoir la section d'insertion (21),
- le canal (111) s'étendant dans le corps de connecteur (11) le long d'un axe de canal (KA) depuis une extrémité proximale du canal dans la direction distale (D), l'extrémité proximale du canal (111P) débouchant dans le côté proximal du corps de connecteur, le canal (111) présentant une face supérieure de canal (111o) ouverte vers la face supérieure du corps de connecteur (11o) et un fond de canal (111a),
- le corps de connecteur (11) étant formé d'un matériau électriquement isolant
b) un élément de connexion électrique, l'élément de connexion électrique comportant une surface de contact de fil (131) disposée dans le canal (11) pour établir le contact avec le segment de fil non isolé (211) et une surface de connexion (132) disposée à l'extérieur sur le corps de connecteur (11) ;
c) un élément de couvercle (12), l'élément de couvercle (12) comportant une structure de serrage, la structure de serrage étant conçue pour, dans la configuration fermée, serrer la section d'insertion (12) entre le fond du canal (111a) et la structure de serrage et maintenir le segment de fil non isolé (211) en contact avec la surface de contact du fil (131),
**caractérisé en ce que**
l'élément de connexion électrique est formé par métallisation, en particulier une métallisation partielle (13), du corps de connecteur (11),
la structure de serrage ne dépasse pas dans le canal (111) dans la configuration ouverte et dépasse dans le canal (111) depuis le côté supérieur ouvert (111o) du canal dans la configuration fermée, et
le fond du canal (111a) et la structure de serrage sont conçus pour déformer le segment de fil non isolé (211) lors du passage de la configuration ouverte à la configuration fermée.

2. Connecteur électrique (1) selon la revendication 1, dans lequel le corps de connecteur (11) et l'élément de couvercle (12) sont moulés d'un seul tenant.

3. Connecteur électrique (1) selon l'une des revendications précédentes, dans lequel le corps de connecteur (11) et l'élément de couvercle (12) sont reliés au moyen d'une charnière (14), la charnière (14) reliant de manière pivotante le côté distal du corps de connecteur (11D) et un côté distal de l'élément de couvercle (12D) et présente un axe de charnière (SA) orienté transversalement par rapport au canal (111).

4. Connecteur électrique (1) selon l'une des revendications précédentes, le connecteur électrique comprenant un dispositif d'encliquetage, le dispositif d'encliquetage comprenant une structure d'encliquetage côté corps de connecteur disposée sur le corps de connecteur (11) et une structure d'encliquetage côté élément de couvercle disposée sur l'élément de couvercle (12), les structures d'encliquetage côté corps de connecteur et côté élément de couvercle étant conçues pour verrouiller, en particulier de manière amovible, le corps de connecteur (11) et l'élément de couvercle (12) par engagement par complémentarité de forme des structures d'encliquetage côté corps de connecteur et côté élément de couvercle.

5. Connecteur électrique (1) selon l'une des revendications précédentes, le connecteur électrique (1) comportant une butée de fil pour le positionnement axial de la section d'insertion par rapport au connecteur électrique.

6. Connecteur électrique (1) selon l'une des revendications précédentes, dans lequel le fond du canal (111a) et la structure de serrage sont conçus pour former un nombre de sections courbes dans le segment de fil non isolé (211) le long de l'axe du canal.

7. Connecteur électrique (1) selon l'une des revendications précédentes, dans lequel la surface de contact de fil (131) s'étend au moins partiellement sur le fond de canal (111a).

8. Connecteur électrique (1) selon l'une des revendications précédentes, dans lequel la surface de contact de fil (131) comprend une pluralité de segments de surface de contact qui sont reliés électriquement entre eux par un conducteur de connexion (133) de la métallisation (13).

9. Connecteur électrique (1) selon l'une des revendications précédentes, le connecteur électrique comportant un dispositif de décharge de traction.

10. Connecteur électrique (1) selon l'une des revendications précédentes, le fond du canal (111a) se terminant à une extrémité distale du canal par un logement d'extrémité, le logement d'extrémité étant conçu pour recevoir une section d'extrémité (23) du segment de fil non isolé (211) s'étendant à partir de l'extrémité du fil, le logement d'extrémité s'étendant selon un angle, en particulier un angle droit, par rapport à l'axe du canal.

11. Connecteur électrique (1) selon l'une des revendications précédentes, dans lequel une métallisation (13) relie électriquement la surface de contact du fil (131) et la surface de connexion (132) à travers une ou plusieurs ouvertures du corps du connecteur (11).

12. Connecteur électrique (1) selon l'une des revendications précédentes, dans lequel le corps de connecteur (11) comporte une structure de connexion, en particulier au moins une broche de connexion en saillie (116), la surface de connexion (132) étant disposée au moins en partie sur la structure de connexion.

13. Connecteur électrique (1) selon l'une des revendications précédentes, dans lequel l'élément de couvercle (12) comporte des éléments de guidage, les éléments de guidage s'étendant dans la configuration fermée depuis la face supérieure (11o) du corps de connecteur des deux côtés de l'axe de canal (KA) dans le corps de connecteur (11).

14. Ensemble connecteur-fil comprenant un connecteur électrique (1) selon l'une des revendications précédentes et un fil (2) avec une extrémité de fil (22), dans lequel un segment de fil non isolé (211) s'étendant à partir de l'extrémité de fil (22) et un segment de fil isolé (212) adjacent au segment de fil non isolé (211) forment ensemble une section d'insertion (12), la section d'insertion (12) étant logée dans le canal (111).

15. Procédé de raccordement d'un fil, le procédé comprenant :
- la fourniture d'un connecteur électrique selon l'une des revendications 1 à 13 dans une configuration ouverte, ainsi que d'un fil (2) avec une extrémité de fil (22), où un segment de fil non isolé s'étendant à partir de l'extrémité de fil (22) et un segment de fil isolé (212) adjacent au segment de fil non isolé (211) formant ensemble une section d'insertion (12) ;
- transfert du connecteur électrique (1) de la configuration ouverte à la configuration fermée, de sorte que la section d'insertion (12) est insérée dans le canal et serrée entre la structure de serrage et le fond du canal, et que le segment de fil non isolé (211) est déformé et mis en contact avec la surface de contact du fil (131).
